# EUROPEAN PATENT APPLICATION

(11) **EP 2 645 439 A2**
(43) Date of publication of application: **02.10.2013**
(21) Application number: 13160997.6
(22) Date of filing: 26.03.2013
(51) Int. Cl.: H01L 41/39, H01L 41/08, H01L 41/187

(54) **PZT-Based ferroelectric thin film and method of manufacturing the same**

(30) Priority: 30.03.2012 JP 2012079194
(71) Applicant: Mitsubishi Materials Corporation, Chiyoda-ku Tokyo 100-8117 (JP)
(72) Inventor: Noguchi, Takashi, Naka-shi, Ibaraki 311-0102 (JP); Doi, Toshihiro, Naka-shi, Ibaraki 311-0102 (JP); Sakurai, Hideaki, Naka-shi, Ibaraki 311-0102 (JP); Watanabe, Toshiaki, Sanda-shi, Hyogo 669-1339 (JP); Soyama, Nobuyuki, Naka-shi, Ibaraki 311-0102 (JP)
(74) Representative: Gille Hrabal

(57) **Abstract**

Task: To provide a PZT-based ferroelectric thin film having higher lifetime reliability while maintaining the same dielectric characteristics as a ferroelectric thin film of the related art and a method of manufacturing the same.

Means for Resolution: A PZT-based ferroelectric thin film (12+13) formed on a lower electrode (11) of a substrate (10) having the lower electrode (11) in which the crystal plane is oriented in a (111) axis direction, having an orientation controlling layer (12) which is formed on the lower electrode and has a layer thickness in which a crystal orientation is controlled in a (100) plane preferentially in a range of 45 nm to 150 nm, and a film thickness adjusting layer (13) which is formed on the orientation controlling layer (12) and has the same crystal orientation as the crystal orientation of the orientation controlling layer (12), in which an interface (14) is formed between the orientation controlling layer (12) and the film thickness adjusting layer (13).

## Description

### [Technical Field]

The present invention relates to a PZT-based ferroelectric thin film applicable to an electronic component such as a capacitor and a piezoelectric element and a method of manufacturing the same, and, particularly, to a PZT-based ferroelectric thin film having improved lifetime reliability and a method of manufacturing the same.

### [Background Art]

In recent years, due to a demand for additional reduction in the size of electronic components, efforts have been made to research, develop and put into practical use techniques for applying a ferroelectric thin film to electronic components, such as capacitors and piezoelectric elements. A ferroelectric thin film having the (100) plane preferentially crystal-oriented has a large piezoelectric constant e₃₁, and is thus suitable for use in actuators and the like.

Lead zirconate titanate (PZT) is a ferroelectrics having a perovskite structure and exhibiting excellent dielectric characteristics. When the PZT is used as a dielectric thin film material, it is possible to obtain excellent capacitors or piezoelectric elements. Therefore, a technique for forming a PZT-based ferroelectric thin film by applying chemical solution deposition (CSD), in which film-forming processes are cheap, and a sol-gel liquid which produces a uniform film composition in a substrate is used, has been distributed. Additionally, an electronic component including a PZT-based ferroelectric thin film also needs to withstand long-term use, and higher lifetime reliability has been becoming necessary. Therefore, thus far, a method for improving the lifetime reliability by adding elements such as La and Nb to PZT has been proposed (for example, refer to Patent Documents 1 and 2). In addition, with attention on the film structure of a PZT-based ferroelectric thin film, a method for improving the lifetime reliability by employing a structure in which the microstructure of the PZT-based ferroelectric thin film is controlled is proposed (for example, refer to Patent Document 3).

### [Related art document]

### [Patent Document]

[Patent Document 1] Japanese Unexamined Patent Application Publication No. 10-335596
[Patent Document 2] Japanese Unexamined Patent Application Publication No. 2009-170695
[Patent Document 3] Japanese Unexamined Patent Application Publication No. 2012-9800 (Claim 1 and paragraph [0007])

### [Disclosure of the Invention]

### [Problem that the Invention is to Solve]

However, while it is possible to extend the lifetime of the electronic components, such as a capacitor and a piezoelectric element, to a certain extent using the methods for improving the lifetime reliability described in Patent Documents 1 to 3, in order to meet a demand for ensuring higher lifetime reliability while maintaining the same dielectric characteristics as a dielectric thin film of the related art, the present inventors carried out intensive studies and, consequently, achieved the invention.

An object of the invention is to provide a PZT-based ferroelectric thin film having higher lifetime reliability while maintaining the same dielectric characteristics as a dielectric thin film of the related art and a method of manufacturing the same.

### [Means for Solving the Problems]

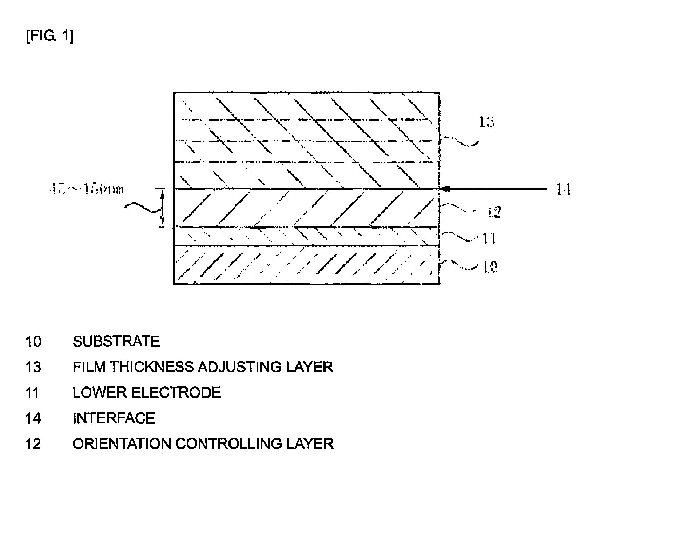

A first aspect of the invention is a PZT-based ferroelectric thin film formed on a lower electrode 11 of a substrate 10 having the lower electrode 11 in which the crystal plane is oriented in a (111) axis direction as shown in Fig. 1, having an orientation controlling layer 12 which is formed on the lower electrode 11 and has a layer thickness in which a crystal orientation is controlled in a (100) plane preferentially in a range of 45 nm to 150 nm, and a film thickness adjusting layer 13 which is formed on the orientation controlling layer 12 and has the same crystal orientation as the crystal orientation of the orientation controlling layer 12, in which an interface 14 is present between the orientation controlling layer 12 and the film thickness adjusting layer 13.

A second aspect of the invention is a PZT-based ferroelectric thin film based on the first aspect, in which, furthermore, the average value of the maximum directed diameter of crystal grains present in the orientation controlling layer 12 is in a range of 200 nm to 5000 nm.

A third aspect of the invention is a PZT-based ferroelectric thin film based on the first or second aspect, in which, furthermore, the film thickness of the PZT-based ferroelectric thin film is in a range of 100 nm to 5000 nm.

A fourth aspect of the invention is a PZT-based ferroelectric thin film based on the third aspect, in which, furthermore, the PZT-based ferroelectric thin film is for a capacitor, and the film thickness of the PZT-based ferroelectric thin film is in a range of 100 nm to 500 nm.

A fifth aspect of the invention is a PZT-based ferroelectric thin film based on the third aspect, in which, furthermore, the PZT-based ferroelectric thin film is for a piezoelectric element, and the film thickness of the PZT-based ferroelectric thin film is in a range of 1000 nm to 5000 nm.

A sixth aspect of the invention is a method of manufacturing a PZT-based ferroelectric thin film on the lower electrode 11 by coating, calcining, and then firing so as to crystallize a PZT-based ferroelectric thin film-forming composition on the lower electrode 11 of the substrate 10 having the lower electrode 11 in which the crystal plane is oriented in the (111) axis direction, in which some of the PZT-based ferroelectric thin film-forming composition is coated, calcined, and fired on the lower electrode 11 so as to form the orientation controlling layer 12, the remainder of the PZT-based ferroelectric thin film-forming composition is coated, calcined, and fired on the orientation controlling layer 12 so as to form the film thickness adjusting layer 13 having the same crystal orientation as the crystal orientation of the orientation controlling layer, calcination and firing are controlled during formation of the orientation controlling layer 12 so as to have the interface 14 between the orientation controlling layer 12 and the film thickness adjusting layer 13, and the coating amount of some of the PZT-based ferroelectric thin film-forming composition is set so that the layer thickness of the crystallized orientation controlling layer 12 becomes in a range of 45 nm to 150 nm, thereby making crystal orientations in the orientation controlling layer 12 preferentially oriented in the (100) plane.

A seventh aspect of the invention is to provide a complex electronic component, such as a thin film capacitor, a capacitor, an IPD, a DRAM memory capacitor, a laminate capacitor, a gate insulator in a transistor, a non-volatile memory, a pyroelectric infrared detecting element, a piezoelectric element, an electro-optic element, an actuator, a resonator, a ultrasonic motor or an LC noise filter element, having a PZT-based ferroelectric thin film manufactured using the method based on the sixth aspect.

### [Advantage of the Invention]

According to the PZT-based ferroelectric thin film of the first aspect of the invention, in the PZT-based ferroelectric thin film formed on the lower electrode of the substrate having the lower electrode in which the crystal plane is oriented in a (111) axis direction, since the PZT-based ferroelectric thin film has the orientation controlling layer which is formed on the lower electrode and has a layer thickness in which a crystal orientation is controlled in a (100) plane preferentially in a range of 45 nm to 150 nm, and the film thickness adjusting layer which is formed on the orientation controlling layer and has the same crystal orientation as the crystal orientation of the orientation controlling layer, and the interface is formed between the orientation controlling layer and the film thickness adjusting layer, the interface introduced into the inside of the PZT-based ferroelectric thin film plays a role of a trap which suppresses the mobility of oxygen defects. Thereby, it is possible to generate a delay phenomenon of the maximum leak current caused by the decrease in the mobility of oxygen defects, and it also becomes possible to have high lifetime reliability.

In the PZT-based ferroelectric thin film of the second aspect of the invention, since the PZT-based ferroelectric thin film is a PZT-based ferroelectric thin film based on the first aspect, and the average value of the maximum directed diameter of crystal grains present in the orientation controlling layer 12 is in a range of 200 nm to 5000 nm, it become possible to have higher lifetime reliability.

In the PZT-based ferroelectric thin film of the third aspect of the invention, since the PZT-based ferroelectric thin film is a PZT-based ferroelectric thin film based on the first or second aspect, and the layer thickness of the PZT-based ferroelectric thin film is 100 nm to 5000 nm, it becomes possible to provide a PZT-based ferroelectric thin film having higher lifetime reliability and a relatively thick total film thickness.

In the PZT-based ferroelectric thin film of the fourth aspect of the invention, since the PZT-based ferroelectric thin film is a PZT-based ferroelectric thin film based on the third aspect, furthermore, is for a capacitor, and the film thickness of the PZT-based ferroelectric thin film is in a range of 100 nm to 500 nm, it becomes possible to provide a capacitor having higher lifetime reliability.

In the PZT-based ferroelectric thin film of the fifth aspect of the invention, since the PZT-based ferroelectric thin film is a PZT-based ferroelectric thin film based on the third aspect, and the film thickness of the PZT-based ferroelectric thin film is in a range of 1000 nm to 5000 nm, it becomes possible to provide a piezoelectric element having higher lifetime reliability.

In the method of manufacturing a PZT-based ferroelectric thin film of the sixth aspect of the invention, it is possible to manufacture the PZT-based ferroelectric thin film of the first aspect. Therefore, since the PZT-based ferroelectric thin film has the orientation controlling layer 12 which is formed on the lower electrode 11 and has a layer thickness in which a crystal orientation is preferentially controlled in the (100) plane in a range of 45 nm to 150 nm, and the film thickness adjusting layer 13 which is formed on the orientation controlling layer 12 and has the same crystal orientation as the crystal orientation of the orientation controlling layer 12, and the interface 14 is present between the orientation controlling layer 12 and the film thickness adjusting layer 13, when the interface is formed between the orientation controlling layer and the film thickness adjusting layer, the interface introduced into the inside of the PZT-based ferroelectric thin film plays a role of a trap which suppresses the mobility of oxygen defects. Thereby, it is possible to generate a delay phenomenon of the maximum leak current caused by the decrease in the mobility of oxygen defects, and a PZT-based ferroelectric thin film having higher lifetime reliability can be provided.

### [Brief Description of the Drawings]

Fig. 1 is a schematic view of the cross-sectional structure of the PZT-based ferroelectric thin film, the substrate, and the lower electrode of the invention.

### [Best Mode for Carrying Out the Invention]

### <Configuration of the PZT-based ferroelectric thin film>

First, the configuration of the PZT-based ferroelectric thin film, which is an embodiment for carrying out the invention, will be described with reference to Fig. 1. The PZT-based ferroelectric thin film according to the invention is an improvement of a PZT-based ferroelectric thin film having an orientation controlling layer 12 and a film thickness adjusting layer 13 on a lower electrode 11 by coating and heating so as to crystallize a PZT-based ferroelectric thin film-forming composition on the lower electrode 11 of a substrate 10 having the lower electrode 11 in which the crystal plane is oriented in a (111) axis direction as shown in Fig. 1. The characteristic configuration of the invention is that an interface 14 is formed at an appropriate location in accordance with the total film thickness according to the use of the PZT-based ferroelectric thin film, more specifically, at a location of 45 nm to 150 nm above the lower electrode 11, which substantially matches the layer thickness of the orientation controlling layer between the orientation controlling layer 12 and the film thickness adjusting layer 13.

Hereinafter, the substrate 10 having the lower electrode 11 on which the PZT-based ferroelectric thin film is formed, the orientation controlling layer 12 and the film thickness adjusting layer 13 which become the foundation layers of the PZT-based ferroelectric thin film will be described, and, subsequently, the interface 14 will be described.

The substrate 10 is made of a heat-resistant substrate such as a silicon substrate or a sapphire substrate. In addition, the lower electrode 11 is formed by depositing a material which has a conductivity and does not react with the PZT-based ferroelectric thin film, such as Pt, Ir, or Ru, on the substrate 10 using a sputtering method. In the lower electrode 11, the crystal plane is oriented in the (111) axis direction.
The orientation controlling layer 12 is a Pb-containing perovskite PZT-based ferroelectric layer which is formed on the above lower electrode 11 in which the crystal plane of the substrate 10 is oriented in the (111) axis direction, and has the crystal orientation preferentially controlled in the (100) plane. In addition, the orientation controlling layer 12 is made to have a film thickness in a range of 45 nm to 150 nm after crystallization. When the layer thickness of the crystallized orientation controlling layer 12 to be formed in the above range is specified, it is possible to readily obtain a PZT-based ferroelectric thin film in which the crystal orientation is preferentially controlled in the (100) plane.

It is assumed that the orientation controlling layer 12 can be crystal-oriented preferentially in the (100) plane because the orientation controlling layer is self-oriented so that the surface energy becomes the minimum. As described above, the layer thickness of the crystallized orientation controlling layer 12 is 45 nm to 150 nm. The reason is that there is a disadvantage that it becomes difficult to obtain a uniform continuous film at a layer thickness of less than 45 nm, and there is a disadvantage that the orientation controlling layer 12 is not (100)-oriented, but (111)-oriented or the like at a layer thickness of more than 150 nm. Furthermore, the average value of the maximum directed diameter of crystal grains present in the orientation controlling layer 12 is preferably set in a range of 200 nm to 5000 nm. The reason is that, when the average value is less than 200 nm, there is a disadvantage that the orientation controlling layer 12 is not (100)-oriented, but (111)-oriented or the like, and, when the average value exceeds 500 nm, there is a disadvantage that it becomes difficult to manufacture a uniform film. Meanwhile, the average value of the maximum directed diameter of crystal grains present in the orientation controlling layer is a value obtained by photographing the surface of the ferroelectric thin film using a scanning electron microscope (hereinafter referred to as SEM), measuring the crystal grain diameters of 100 arbitrary crystal grains on the photographed SEM image at the maximum directed diameter (Krummbein diameter), and computing the average thereof.

Next, the film thickness adjusting layer 13 formed on the orientation controlling layer 12 will be described. In the film thickness adjusting layer 13, a crystal orientation plane having the same tendency as the orientation controlling layer 12 is formed along the preferentially oriented plane of the orientation controlling layer 12. When the layer thickness of the film thickness adjusting layer 13 is changed, the total film thickness of the PZT-based ferroelectric thin film can be increased and decreased, and, simultaneously, it is possible to manufacture a PZT-based ferroelectric thin film in which the crystal orientation is preferentially controlled in the (100) plane when the preferentially oriented plane of the orientation controlling layer 12 is the (100) plane. The film thickness adjusting layer 13 is the same Pb-containing perovskite PZT-based ferroelectric film as the orientation controlling layer 12. The layer thickness of the film thickness adjusting layer 13 is preferably less than 5000 nm. The reason for specifying the layer thickness of the film thickness adjusting layer 13 as above is that, when the layer thickness is 5000 nm or more, the process time increases, the tendency of following the preferentially oriented plane of the orientation controlling layer 12 decreases, and, consequently, the degree of orientation in the (100) plane decreases.

### <PZT-based ferroelectric thin film-forming composition>

Next, a PZT-based ferroelectric thin film-forming composition, which becomes raw materials of the orientation controlling layer 12 and the film thickness adjusting layer, will be described. The PZT-based ferroelectric thin film-forming composition is prepared using an organic metal compound solution which contains raw materials for configuring a complex metal oxide dissolved in an organic solvent so as to obtain a ratio at which a desired metal atomic ratio is supplied. The PZT-based ferroelectric thin film to be manufactured is preferably a Pb-containing perovskite oxide, and the ferroelectric thin film may be based on PLZT, PMnZT, PNbZT, or the like other than PZT.

The raw material of the complex metal oxide is preferably a compound in which organic groups are bonded to the respective metal elements of Pb, La, Zr and Ti through oxygen or nitrogen atoms thereof. Examples thereof include one or two or more selected from a group consisting of metal alkoxides, metal diol complexes, metal triol complexes, metal carboxylates, metal β-diketonate complexes, metal β-diketoester complexes, metal β-iminoketo complexes and metal amino complexes. A particularly preferable compound is a metal alkoxide, a partial hydrolysate thereof, an organic salt. Among the above, examples of a Pb compound and a La compound include acetates (lead acetate: Pb(OA_{c})₂, lanthanum acetate: La(OA_{c})₃), lead diisopropoxide: Pb(OiPr)₂, lanthanum triisopropoxide: La(OiPr)₃, and the like. Examples of a Ti compound include alkoxides such as titanium tetraethoxide: Ti(OEt)₄, titanium tetraisopropoxide: Ti(OiPr)₄, titanium tetra n-butoxide: Ti(OiBu)₄, titanium tetraisobutoxide: Ti(OiBu)₄, titanium tetra t-butoxide: Ti(OtBu)₄, and titanium dimethoxy diisopropoxide: Ti(OMe)₂(OiPr)₂. As a Zr compound, the same alkoxide as for the Ti compound is preferable. The metal alkoxide may be used as it is, but a partial hydrolysate thereof may be used in order to accelerate decomposition.

A PZT-based ferroelectric thin film-forming composition using the above raw material is prepared in the following manner. First, the raw materials are dissolved in an appropriate solvent at a ratio corresponding to a desired PZT-based ferroelectric thin film composition, and are prepared at a concentration suitable for coating. This preparation enables the obtaining of a PZT-based ferroelectric thin film-forming composition, which becomes a precursor solution, typically using a liquid synthesis flow as below. A Zr source (for example, Zr tetra n-butoxide), a Ti source (for example, Ti isopropoxide), and a stabilizer (for example, acetyl acetone) are put into a reaction vessel, and are refluxed in a nitrogen atmosphere. Next, a Pb source (for example, lead acetate trihydrate) is added to the refluxed compound, a solvent (for example, propylene glycol) is added, the solution is refluxed in a nitrogen atmosphere, is distilled under reduced pressure so as to remove byproducts, then, propylene glycol is further added to the solution so as to adjust the concentration, and, furthermore, 1-butanol is added to this solution. As a result, the PZT-based ferroelectric thin film-forming composition is obtained.

The solvent used here is appropriately determined depending on the raw materials to be used, and general examples thereof that can be used include carboxylic acids, alcohols (for example, propylene glycol which is a multivalent alcohol), esters, ketones (for example, acetone and methyl ethyl ketone), ethers (for example, dimethyl ether and diethyl ether), cycloalkanes (for example, cyclohexane and cyclohexanol), aromatic solvents (for example, benzene, toluene and xylene), other tetrahydrofuran, or a mixed solvent of two or more thereof.

Specific examples of the carboxylic acids that is preferably used include n-butyric acid, α-methyl butyric acid, i-valeric acid, 2-ethyl butyric acid, 2,2-dimethyl butyric acid, 3,3-dimethyl butyric acid, 2,3-dimethyl butyric acid, 3-methyl pentanoic acid, 4-methyl pentanoic acid, 2-ethyl pentanoic acid, 3-ethyl pentanoic acid, 2,2-dimethyl pentanoic acid, 3,3-dimethyl pentanoic acid, 2,3-dimethyl pentanoic acid, 2-ethyl hexanoic acid, and 3-ethyl hexanoic acid.

In addition, ethyl acetate, propyl acetate, n-butyl acetate, sec-butyl acetate, tert-butyl acetate, isobutyl acetate, n-amyl acetate, sec-amyl acetate, tert-amyl acetate or isoamyl acetate is preferably used as the ester, and 1-propanol, 2-propanol, 1-butanol, 2-butanol, isobutyl alcohol, 1-pentanol, 2-pentanol, 2-methyl-2-pentanol, or 2-methoxy ethanol is preferably used as the alcohol.

The total concentration of an organic metallic compound in the organic metal compound solution of the PZT-based ferroelectric thin film-forming composition is preferably set to approximately 0.1 mass% to 20 mass% in terms of the amount of the metal oxide.

In this organic metal compound solution, a β-diketone (for example, acetyl acetone, heptafluorobutanoyl pivaloyl methane, dipivaloyl methane, trifluoroacetyl acetone, benzoyl acetone, or the like), a β-ketonic acid (for example, acetoacetic acid, propionyl acetate, benzoyl acetate, or the like), a β-ketoester (for example, a lower alkyl ester such as methyl, propyl, or butyl of the above ketonic acid), an oxyacid (for example, lactic acid, glycolic acid, α-hydroxybutyric acid, salicylic acid, or the like), a lower alkyl ester of the above oxyacid, an oxyketone (for example, diacetone alcohol, acetoine, or the like), a diol, a triol, a higher carboxylic acid, an alkanol amine (for example, diethanolamine, triethanolamine, monoethanolamine), a multivalent amine, or the like may be added as a stabilizer as necessary (the number of molecules of the stabilizer)/(the number of metal atoms) of approximately 0.2 to 3.

The PZT-based ferroelectric thin film-forming composition preferably includes a β-diketone and a multivalent alcohol. Among the above, acetyl acetone is particularly preferable as the β-diketone, and propylene glycol is particularly preferable as the multivalent alcohol.

Further, particles that may be present in the solution may be removed as necessary by carrying out a filtration treatment or the like on the prepared organic metal compound solution. This is to secure the long-term storage stability of the organic metal compound solution.

### <Method of forming the PZT-based ferroelectric thin film>

Next, a method of forming a PZT-based ferroelectric thin film by coating, calcining, and firing a solution including the PZT-based ferroelectric thin film-forming composition, which has been prepared in the above, on the lower electrode 11 of the substrate 10 of the orientation controlling layer 12 and the film thickness controlling layer 13 will be described hereinafter.

First, the orientation controlling layer 12 is formed by coating a solution including the prepared PZT-based ferroelectric thin film-forming composition on the lower electrode 11 using a coating method such as spin coating, dip coating, or liquid source misted chemical deposition (LSMCD), carrying out drying and calcination using a hot plate or the like, forming a gel film so that the layer thickness becomes 45 nm to 150 nm after firing, and then firing the composition.

Next, the film thickness adjusting layer 13 is formed on the orientation controlling layer 12 in the following manner. The same solution is coated using the same coating method as above, is dried and calcined using a hot plate or the like, the processes from coating through drying and calcination are repeated, a gel film having a layer thickness in a desired range is formed, and then fired at once, or the processes from coating through firing are repeated depending on the necessary total film thickness, thereby forming the film thickness adjusting layer. For example, in the schematic cross-sectional view of Fig. 1, there are three dotted-line portions, and one dotted-line portion corresponds to one cycle of the processes from coating through drying and calcination. That is, the film thickness adjusting layer 13 in Fig. 1 is an example of a layer manufactured by repeating the processes from coating through drying and calcination four times. The total film thickness of the PZT-based ferroelectric thin film is adjusted using the film thickness adjusting layer 13, but the layer thickness of the film thickness adjusting layer 13 is adjusted depending on the use of the same thin film, for example, whether the thin film is for a capacitor or for a piezoelectric element.

Next, drying, calcination and firing, which are common for the orientation controlling layer 12 and the film thickness controlling layer 13, will be described hereinafter.

Drying and calcination are carried out in order to remove the solvent and to thermally decompose or hydrolyze the organic metal compound so as to transform the organic metal compound into a complex oxide. Therefore, drying and calcination is carried out in the atmosphere, an oxidation atmosphere, or a water vapor-including atmosphere. Moisture necessary for hydrolysis is sufficiently secured from the humidity in the air even during heating in the air. This heating may be carried out in two steps of low-temperature heating for removing the solvent and high-temperature heating for decomposing the organic metal compound. Drying and calcination are carried out at a treatment temperature of 150°C to 550°C for a treatment time of approximately 1 minute to 10 minutes. Firing is a process for heating a thin film obtained through drying and calcination at a temperature that is the crystallization temperature or higher so as to crystallize the thin film, and the PZT-based ferroelectric thin film is obtained through firing. The firing atmosphere in the crystallization process is preferably O₂, N₂, Ar, N₂O, H₂, a gas mixture thereof, or the like. Firing is carried out at a treatment temperature of 450°C to 800°C for a treatment time of approximately 1 minute to 60 minutes. Firing may be carried out through a rapid thermal annealing (RTA) treatment. In a case in which firing is carried out through the RTA treatment, the temperature-rise rate is preferably set to 10°C/second to 100°C/second.

The interface 14, which is a characteristic of the invention, is formed between the process in which the orientation controlling layer 12 is formed and the process in which the film thickness adjusting layer 13 is formed. The presence of the interface 14 leads to higher lifetime reliability. This is assumed that, since the interface introduced into the inside of the PZT-based ferroelectric thin film plays a role of a trap which suppresses the mobility of oxygen defects, and a delay phenomenon of the maximum leak current is caused due to a decrease in the mobility of oxygen defects, high lifetime reliability is obtained.

The PZT-based ferroelectrics manufactured in the above manner preferably has a total film thickness in a range of 100 nm to 500 nm. The reason for limiting to the above range is that, when the total film thickness is less than 100 nm, there is a disadvantage that the insulation pressure resistance of the PZT-based ferroelectric thin film decreases, and, when the total film thickness exceeds 500 nm, there is a disadvantage that the electrostatic capacitance decreases as a capacitor. In addition, the PZT-based ferroelectrics manufactured in the same method preferably has a total film thickness in a range of 1000 nm to 5000 nm for the use in piezoelectric elements. The reason for limiting to the above range is that, when the total film thickness is less than 1000 nm, there is a disadvantage that a piezoelectric driving force necessary for the piezoelectric element cannot be secured, and, when the total film thickness exceeds 5000 nm, there is a disadvantage that the process time increases.

As thus far described in the embodiment, the PZT-based ferroelectric thin film of the invention can have higher lifetime reliability while maintaining the same dielectric characteristics as a ferroelectric thin film of the related art.

In addition, the ferroelectric thin film of the invention can be preferably applied as a component material of a complex electronic component, such as a thin film capacitor, a capacitor, an IPD, a DRAM memory capacitor, a laminate capacitor, a gate insulator in a transistor, a non-volatile memory, a pyroelectric infrared detecting element, a piezoelectric element, an electro-optic element, an actuator, a resonator, a ultrasonic motor or an LC noise filter element.

### [Examples]

Next, examples of the invention will be described in detail along with comparative examples.

First, preparation of a solution of a PZT-based ferroelectric composition, which is common in examples and comparative examples, will be mentioned. Zirconium tetra n-butoxide and acetyl acetone as a stabilizer were added to a reaction vessel, and refluxed in a nitrogen atmosphere at a temperature of 150°C. Titanium tetraisopropoxide and acetyl acetone as a stabilizer were added to the mixture, and refluxed in a nitrogen atmosphere at a temperature of 150°C. Next, lead acetate trihydrate and propylene glycol as a solvent were added to the mixture, and refluxed in a nitrogen atmosphere at a temperature of 150°C. After that, the solution was distilled under reduced pressure at 150°C so as to remove byproducts, and, furthermore, a diluted alcohol was added, thereby obtaining a solution of a PZT-based ferroelectric composition adjusted to contain a metal compound having a Pb/Zr/Ti composition ratio of 110/52/48 at a desired concentration in terms of an oxide.

### <Example 1>

As a substrate, a silicon substrate having a Pt lower electrode film formed on the surface using a sputtering method was prepared. The PZT-based ferroelectric composition for the orientation controlling layer having a concentration of 12 mass%, which had been prepared in the above, was coated on the Pt lower electrode film of the substrate using a spin coating method under conditions of 500 rpm for 3 seconds and then 2000 rpm for 20 seconds (hereinafter referred to as the "orientation controlling layer coating step"). Subsequently, the composition was heated at 175°C for 5 minutes in the atmosphere using a hot plate so as to carry out drying and calcination (hereinafter referred to as the "orientation controlling layer calcination step"). A process of coating and calcining the PZT-based ferroelectric composition for the orientation controlling layer was repeated twice, and then firing in which the composition was heated at 700°C and a temperature-rise rate of 10°C/second in the oxygen atmosphere for 1 minute was carried out so as to crystallize the composition, thereby obtaining the orientation controlling layer having a layer thickness of 150 nm (hereinafter the "orientation controlling layer firing step"). Next, the PZT-based ferroelectric composition for the film thickness adjusting layer having a concentration of 10 mass%, which had been prepared in the above, was coated on the orientation controlling layer using a spin coating method under conditions of 500 rpm for 3 seconds and then 3000 rpm for 15 seconds (hereinafter referred to as the "film thickness adjusting layer coating step"). Subsequently, the composition was heated at 350°C for 5 minutes in the atmosphere using a hot plate so as to carry out drying and calcination (the film thickness adjusting layer calcination step"). A process of coating and calcining the PZT-based ferroelectric composition for the film thickness adjusting layer was repeated three times, and then firing in which the composition was heated at 700°C and a temperature-rise rate of 10°C/second in the oxygen atmosphere for 1 minute was carried out so as to crystallize the composition, thereby obtaining the film thickness adjusting layer having a layer thickness of 135 nm (hereinafter the "film thickness adjusting layer firing step"). A PZT-based ferroelectric thin film having a total film thickness of 285 nm was manufactured in the above manner.

### <Example 2>

In the orientation controlling layer coating step, the PZT-based ferroelectric composition for the orientation controlling layer having a concentration of 12 mass%, which had been adjusted in the above, was coated under conditions of 500 rpm for 3 seconds and then 2000 rpm for 20 seconds. In the orientation controlling layer calcination step, the drying and calcination conditions were at 175°C for 5 minutes. The orientation controlling layer coating step and the orientation controlling layer calcination step were carried out only once. In the orientation controlling layer calcination step, the drying and calcination conditions were at 175°C for 5 minutes. The orientation controlling layer coating step and the orientation controlling layer calcination step were carried out only once. Thereby, the orientation controlling layer having a layer thickness of 75 nm was obtained. In the film thickness adjusting layer coating step, the coating conditions were at 500 rpm for 3 seconds and then 3000 rpm for 15 seconds. In the film thickness adjusting layer calcination step, the drying and calcination conditions were at 350°C for 5 minutes. The film thickness adjusting layer coating step and the film thickness adjusting layer calcination step were repeated five times. Thereby, the film thickness adjusting layer having a layer thickness of 225 nm was obtained. A PZT-based ferroelectric thin film having a total film thickness of 300 nm was manufactured in the same manner as in Example 1 except the above.

### <Example 3>

In the orientation controlling layer coating step, the PZT-based ferroelectric composition for the orientation controlling layer having a concentration of 10 mass%, which had been adjusted in the above, was coated under conditions of 500 rpm for 3 seconds and then 3000 rpm for 15 seconds. In the orientation controlling layer calcination step, the drying and calcination conditions were at 250°C for 5 minutes. The orientation controlling layer coating step and the orientation controlling layer calcination step were carried out only once. Thereby, the orientation controlling layer having a layer thickness of 45 nm was obtained. In the film thickness adjusting layer coating step, the drying and calcination conditions were at 500 rpm for 3 seconds and then 3000 rpm for 15 seconds. In the film thickness adjusting layer calcination step, the drying and calcination conditions were at 350°C for 5 minutes. The film thickness adjusting layer coating step and the film thickness adjusting layer calcination step were repeated five times. Thereby, the film thickness adjusting layer having a layer thickness of 225 nm was obtained. A PZT-based ferroelectric thin film having a total film thickness of 270 nm was manufactured in the same manner as in Example 1 except the above.

### <Comparative example 1>

In the orientation controlling layer coating step, the PZT-based ferroelectric composition for the orientation controlling layer having a concentration of 10 mass%, which had been adjusted in the above, was coated under conditions of 500 rpm for 3 seconds and then 3000 rpm for 15 seconds. In the orientation controlling layer calcination step, the orientation controlling layer coating step and the orientation controlling layer calcination step, for which the drying and calcination conditions were set at 350°C for 5 minutes, were repeated six times. Thereby, the orientation controlling layer having a layer thickness of 270 nm was obtained. A PZT-based ferroelectric thin film having a total film thickness of 270 nm was manufactured in the same manner as in Example 1 except the above. Further, in the same thin film of Comparative example 1, there was no film thickness controlling layer, that is, there was no interface.

### <Example 4>

In the orientation controlling layer coating step, the PZT-based ferroelectric composition for the orientation controlling layer having a concentration of 10 mass%, which had been adjusted in the above, was coated under conditions of 500 rpm for 3 seconds and then 3000 rpm for 15 seconds. In the orientation controlling layer calcination step, the drying and calcination conditions were set at 250°C for 5 minutes. The orientation controlling layer coating step and the orientation controlling layer calcination step were repeated twice. Thereby, the orientation controlling layer having a layer thickness of 90 nm was obtained. In the film thickness adjusting layer coating step, the coating conditions were set to 500 rpm for 3 seconds and then 3000 rpm for 15 seconds. In the film thickness adjusting layer calcination step, the drying and calcination conditions were set at 350°C for 5 minutes. The film thickness adjusting layer coating step and the film thickness adjusting layer calcination step were repeated once. Thereby, the film thickness adjusting layer having a layer thickness of 45 nm was obtained. A PZT-based ferroelectric thin film having a total film thickness of 135 nm was manufactured in the same manner as in Example 1 except the above.

### <Comparative example 2>

In the orientation controlling layer coating step, the PZT-based ferroelectric composition for the orientation controlling layer having a concentration of 12 mass%, which had been adjusted in the above, was coated under conditions of 500 rpm for 3 seconds and then 2000 rpm for 20 seconds. In the orientation controlling layer calcination step, the drying and calcination conditions were set at 175°C for 5 minutes. The orientation controlling layer coating step and the orientation controlling layer calcination step were repeated twice. Thereby, the orientation controlling layer having a layer thickness of 150 nm was obtained. A PZT-based ferroelectric thin film having a total film thickness of 150 nm was manufactured in the same manner as in Example 1 except the above. Further, in the same thin film of Comparative example 2, there was no film thickness controlling layer, that is, there was no interface.

### <Comparative example 3>

In the orientation controlling layer coating step, the PZT-based ferroelectric composition for the orientation controlling layer having a concentration of 10 mass%, which had been adjusted in the above, was coated under conditions of 500 rpm for 3 seconds and then 3000 rpm for 15 seconds. In the orientation controlling layer calcination step, the drying and calcination conditions were set at 350°C for 5 minutes. The orientation controlling layer coating step and the orientation controlling layer calcination step were repeated three times. Thereby, the orientation controlling layer having a layer thickness of 135 nm was obtained. A PZT-based ferroelectric thin film having a total film thickness of 135 nm was manufactured in the same manner as in Example 1 except the above. Further, in the same thin film of Comparative example 3, there was no film thickness controlling layer, that is, there was no interface.

### <Example 5>

In the orientation controlling layer coating step, the PZT-based ferroelectric composition for the orientation controlling layer having a concentration of 12 mass%, which had been adjusted in the above, was coated under conditions of 500 rpm for 3 seconds and then 2000 rpm for 20 seconds. In the orientation controlling layer calcination step, the drying and calcination conditions were set to 175°C for 5 minutes. The orientation controlling layer coating step and the orientation controlling layer calcination step were carried out only once. Thereby, the orientation controlling layer having a layer thickness of 75 nm was obtained. In the film thickness adjusting layer coating step, the coating conditions were at 500 rpm for 3 seconds and then 3000 rpm for 15 seconds. In the film thickness adjusting layer calcination step, the drying and calcination conditions were at 350°C for 5 minutes. The orientation controlling layer coating step and the orientation controlling layer calcination step were repeated six times, and firing in which the composition was heated at 700°C for 1 minute in an oxygen atmosphere at a temperature-rise rate of 10°C/second was carried out so as to crystallize the composition, thereby obtaining a crystal layer having a layer thickness of 270 nm. After a process for manufacturing the crystal layer was repeated 18 times, again, the orientation controlling layer coating step and the orientation controlling layer calcination step were carried out only once, and then firing in which the composition was heated at 700°C for 1 minute in an oxygen atmosphere at a temperature-rise rate of 10°C/second was carried out so as to crystallize the composition. Thereby, the film thickness adjusting layer having a layer thickness of 4905 nm was obtained. A PZT-based ferroelectric thin film having a total film thickness of 4980 nm was manufactured in the same manner as in Example 1 except the above.

### <Comparative example 4>

In the orientation controlling layer coating step, the PZT-based ferroelectric composition for the orientation controlling layer having a concentration of 12 mass%, which had been adjusted in the above, was coated under conditions of 500 rpm for 3 seconds and then 2000 rpm for 20 seconds. In the orientation controlling layer calcination step, the drying and calcination conditions were set to 350°C for 5 minutes. The orientation controlling layer coating step and the orientation controlling layer calcination step were carried out only once. Thereby, the orientation controlling layer having a layer thickness of 75 nm was obtained. In the film thickness adjusting layer coating step, the coating conditions were set to 500 rpm for 3 seconds and then 3000 rpm for 15 seconds. In the film thickness adjusting layer calcination step, the drying and calcination conditions were set to 350°C for 5 minutes. The orientation controlling layer coating step and the orientation controlling layer calcination step were repeated six times, and firing in which the composition was heated at 700°C for 1 minute in an oxygen atmosphere at a temperature-rise rate of 10°C/second was carried out so as to crystallize the composition, thereby obtaining a crystal layer having a layer thickness of 270 nm. After a process for manufacturing the crystal layer was repeated 18 times, again, the orientation controlling layer coating step and the orientation controlling layer calcination step were carried out only once, and then firing in which the composition was heated at 700°C for 1 minute in an oxygen atmosphere at a temperature-rise rate of 10°C/second was carried out so as to crystallize the composition. Thereby, the film thickness adjusting layer having a layer thickness of 4905 nm was obtained. A PZT-based ferroelectric thin film having a total film thickness of 4980 nm was manufactured in the same manner as in Example 1 except the above.

### <Comparative example 5>

In the orientation controlling layer coating step, the PZT-based ferroelectric composition for the orientation controlling layer having a concentration of 10 mass%, which had been adjusted in the above, was coated under conditions of 500 rpm for 3 seconds and then 3000 rpm for 15 seconds. In the orientation controlling layer calcination step, the drying and calcination conditions were set to 350°C for 5 minutes. The orientation controlling layer coating step and the orientation controlling layer calcination step were repeated six times. Thereby, the orientation controlling layer having a layer thickness of 270 nm was obtained. In the film thickness adjusting layer coating step, the coating conditions were set to 500 rpm for 3 seconds and then 3000 rpm for 15 seconds. In the film thickness adjusting layer calcination step, the drying and calcination conditions were set to 350°C for 5 minutes. The orientation controlling layer coating step and the orientation controlling layer calcination step were repeated six times, and firing in which the composition was heated at 700°C for 1 minute in an oxygen atmosphere at a temperature-rise rate of 10°C/second was carried out so as to crystallize the composition, thereby obtaining a crystal layer having a layer thickness of 270 nm. After a process for manufacturing the crystal layer was repeated 17 times, again, the orientation controlling layer coating step and the orientation controlling layer calcination step were repeated three times, and then firing in which the composition was heated at 700°C for 1 minute in an oxygen atmosphere at a temperature-rise rate of 10°C/second was carried out so as to crystallize the composition. Thereby, the film thickness adjusting layer having a layer thickness of 4725 nm was obtained. A PZT-based ferroelectric thin film having a total film thickness of 4995 nm was manufactured in the same manner as in Example 1 except the above.

### <Comparison test>

### Tests for comparing the PZT-based ferroelectric thin films of Examples 1 to 5 and Comparative examples 1 to 5 were carried out as follows.

First, the cross-sectional surface of the PZT-based ferroelectric thin film was observed using a SEM (manufactured by Hitachi Science System, Ltd., S-4300SE, resolution 1.5 nm) at an accelerating voltage of 15 kV and a magnification of 10 thousand times to 100 thousand times, the presence of the interface between the orientation controlling layer and the film thickness adjusting layer was confirmed, and the layer thicknesses of the orientation controlling layer and the film thickness adjusting layer and the total film thickness of the PZT-based ferroelectric thin film were measured. In addition, the crystal direction in the preferentially oriented surface of the PZT-based ferroelectric thin film was measured using an X-ray diffraction apparatus (manufactured by Bruker AXS, MXP18VAHF). In addition, the top surface of the PZT-based ferroelectric thin film was photographed using a SEM (manufactured by Hitachi Science System, Ltd., S-4300SE), the crystal grain diameters of 100 arbitrary crystal grains in the photographed SEM image were measured at the maximum directed diameter (Krummbein diameter), and the average was used as the grain diameter of the PZT-based ferroelectric thin film.

In addition, a dot-shaped Pt thin film (area: 3.5×10⁻² mm²) was formed on the PZT-based ferroelectric thin films obtained in Examples 1 to 5 and Comparative examples 1 to 5 using a sputtering method so as to form an upper Pt electrode and thus form a plurality of capacitor structures on the same substrate, and then the capacitor structures were again heated at 700°C in an oxygen atmosphere for 1 minute. For the thin film capacitor obtained in the above manner, the lifetime characteristic was evaluated by carrying out highly accelerated lifetime testing (HALT) in which the thin film capacitor was exposed to a higher load (high temperature and high voltage) environment than conditions ordinarily used. First, the top Pt electrode and the lower Pt electrode on the thin film capacitor were electrically connected. Next, the voltage application durations and the values of leak currents flowing in the respective capacitors were measured while applying a voltage of 14 V in a state in which the thin film capacitors of Examples 1 to 4 and Comparative examples 1 to 3 were heated up to 160°C, and while applying a voltage of 100 V in a state in which the thin film capacitors of Example 5 and Comparative examples 4 and 5 were heated up to 225°C.

As time elapses, an appearance of insulation breakdown occurring due to deterioration of the capacitor and the abruptly increased leak current is confirmed. A duration during which the respective capacitors reached insulation breakdown was read from the measurement data at this time (time-dependent dielectric breakdown (TDDB) evaluation). Specifically, with an assumption that insulation breakdown occur when the leak current value exceeds 100 µA, a statistic calculation using a Weibull distribution analysis was carried out on a plurality of insulation breakdown period data, and the duration in which insulation breakdown occurred in 63.2% of the total number of the capacitors was used as the mean time to failure (hereinafter referred to as the MTF) (refer to paragraphs 0033 to 0038 in Patent Document 3). The reason for using two different heating temperatures and application voltages as above is that the total film thicknesses were 130 nm to 300 nm in Examples 1 to 4 and Comparative examples 1 to 3 (referred to as Group 1), and were 5000 nm or less in Example 5 and Comparative examples 4 and 5 (referred to as Group 2), there was a huge difference in the total film thickness between both groups, and, if the acceleration conditions for Group 2 are not strictly applied to Group 1, the thin film capacitors of Group 2 do not easily reach the breakdown mode, which makes the test meaningless as the acceleration test.

The dielectric constants in the rightmost column in Tables 1 to 3 are initial dielectric constants obtained by evaluating the C-V characteristics (the voltage reliance of the electrostatic capacitance) in a range of -5 V to 5V at a frequency of 1 kHz between the Pt upper electrode and the Pt lower electrode provided on the top surface and the bottom surface of the PZT-based ferroelectric thin film, which were tested in the respective examples and the respective comparative examples, and computing using the maximum value of the electrostatic capacitance. There was no significant and meaningful difference among all dielectric constants. Meanwhile, the C-V characteristics were measured using an LCR meter (manufactured by Hewlett-Packard Company, 4284A) under conditions of bias step 0.1 V, frequency 1 kHz, OSC level 30 mv, delay time 0.2 sec., temperature 23°C, and hygrometry 50±10%.

### <Results of the comparison tests>

The above evaluation results are summarized in Tables 1 to 3. Table 1 is the results of Comparison test 1 in which the results of Examples 1 to 3 and Comparative example 1 are summarized. Table 2 is the results of Comparison test 2 in which the results of Example 4 and Comparative examples 2 and 3 are summarized. Table 3 is the results of Comparison test 3 in which the results of Example 5 and Comparative examples 4 and 5 are summarized.

**[Table 1]**

| | Layer thickness of orientation controlling layer (nm) | Layer thickness of film thickness adjusting layer (nm) | Ferroelectric thin film | | | MTF (seconds) at 160°C, 14 V | MTF (seconds) at 225°C, 100V | Dielectric constant |
|---|---|---|---|---|---|---|---|---|
| | | | Preferentially oriented plane | Grain diameter (nm) | Total film thickness (nm) | | | |
| Example 1 | 150 | 135 | (100) | 200 | 285 | 26100 | - | 1443 |
| Example 2 | 75 | 225 | (100) | 600 | 300 | 28300 | - | 1417 |
| Example 3 | 45 | 225 | (100) | 4500 | 270 | 14700 | - | 1482 |
| Comparative example 1 | 270 | 0 | (111) | 50 | 270 | 3380 | - | 1540 |

**[Table 2]**

| | Layer thickness of orientation controlling layer (nm) | Layer thickness of film thickness adjusting layer (nm) | Ferroelectric thin film | | | MTF (seconds) at 160°C, 14 V | MTF (seconds) at 225°C, 100 V | Dielectric constant |
|---|---|---|---|---|---|---|---|---|
| | | | Preferentially oriented plane | Grain diameter (nm) | Total film thickness (nm) | | | |
| Example 4 | 90 | 45 | (100) | 300 | 135 | 315 | - | 1395 |
| Comparative example 2 | 150 | 0 | (100) | 200 | 150 | 41 | - | 1420 |
| Comparative example 3 | 135 | 0 | (111) | 50 | 135 | 27 | - | 1516 |

**[Table 3]**

| | Layer thickness of orientation controlling layer (nm) | Layer thickness of film thickness adjusting layer (nm) | Ferroelectric thin film | | | MTF (seconds) at 160°C, 14 V | MTF (seconds) at 225°C, 100 V | Dielectric constant |
|---|---|---|---|---|---|---|---|---|
| | | | Preferentially oriented plane | Grain diameter (nm) | Total film thickness (nm) | | | |
| Example 5 | 75 | 4905 | (100) | 600 | 4980 | - | 103000 | 1523 |
| Comparative example 4 | 75 | 4905 | (111) | 400 | 4980 | - | 37600 | 1544 |
| Comparative example 5 | 270 | 4725 | (111) | 50 | 4995 | - | 25400 | 1572 |

### <Evaluation of Comparison test 1>

The PZT-based ferroelectric thin films (hereinafter abbreviated to "PZT films") of Examples 1 to 3 and Comparative example 1 obtained in Comparison test 1 are evaluated with reference to Table 1. The PZT films of Examples 1 to 3 all have the orientation controlling layer and the film thickness adjusting layer, and have the interface between both layers. On the other hand, the PZT film of Comparison example 1 has only the orientation controlling layer, and does not have the interface.

It was found that, in all of the PZT films of Examples 1 to 3 in which the preferentially oriented plane was (100) and the interface was present, compared to the PZT film of Comparative example 1 in which the preferentially oriented surface was (111) and the interface was not present, the total film thicknesses were all in a range of 270 nm to 300 nm, and are substantially the same, and, regarding MTF, the lifetime extended by approximately 4 times to 8 times.

In addition, when Examples 1 to 3 are compared, the total film thicknesses of the PZT films of Examples 1 to 3 were substantially the same in a range of 270 nm to 300 nm, and the thicknesses of the orientation controlling layers were 150 nm, 75 nm, and 45 nm for Examples 1, 2 and 3 respectively. The size of the thickness of the orientation controlling layer has a significant correlation with the grain diameter of the PZT film, and the grain diameters were 200 nm, 600 nm, and 4500 nm for Examples 1, 2, and 3 respectively. Therefore, it was found that the grain diameter of the PZT film increases as the layer thickness of the orientation controlling layer decreases with the same total film thickness.

### <Evaluation of Comparison test 2>

The PZT films of Example 4 and Comparative examples 1 and 2 obtained in Comparison test 2 are evaluated with reference to Table 2. In the PZT film of Example 4, the preferentially oriented plane is (100), the orientation controlling layer and the film thickness adjusting layer are present, and the interface is present between the orientation controlling layer and the film thickness adjusting layer. Meanwhile, in the PZT film of Comparative example 2, the preferentially oriented plane is (100), only the orientation controlling layer is present, and the interface is not present. In addition, in the PZT film of Comparison example 3, the preferentially oriented plane is (111), only the orientation controlling layer is present, and the interface is not present.

It was found that, in the PZT film of Example 4 having the interface, compared to the PZT films of Comparative examples 2 and 3 not having the interface, regarding MTF, the lifetime extended by approximately 8 times to 11 times.

While the thicknesses of the orientation controlling layers were substantially the same in the PZT films of Comparative examples 2 and 3, the preferentially oriented planes were (100) in Comparative example 2 and (111) in Comparative example 3. This results from the manufacturing conditions, and is because the manufacturing conditions of the orientation controlling layers were different in Comparative examples 2 and 3. More specifically, for Comparative example 2, the second spin coating conditions were 2000 rpm for 20 seconds, and the concentration of the PZT-based ferroelectric composition for the orientation controlling layer is 12 mass% in the orientation controlling layer coating step, the temperature condition is 175°C in the orientation controlling layer calcination step, and the repetition number of the orientation controlling layer coating step and the orientation controlling layer calcination step is two. In contrast to this, for Comparative example 3, the second spin coating conditions were 3000 rpm for 15 seconds, and the concentration of the PZT-based ferroelectric composition for the orientation controlling layer is 10 mass% in the orientation controlling layer coating step, the temperature condition is 350°C in the orientation controlling layer calcination step, and the repetition number of the orientation controlling layer coating step and the orientation controlling layer calcination step is three.

### <Evaluation of Comparison test 3>

The PZT films of Example 5 and Comparative examples 4 and 5 obtained in Comparison test 3 are evaluated with reference to Table 3. In the PZT film of Example 5, the preferentially oriented plane is (100), the orientation controlling layer and the film thickness adjusting layer are present, and the interface is present between both layers. On the other hand, in all of the PZT films of Comparison examples 4 and 5, the preferentially oriented planes are (111), the orientation controlling layer and the film thickness adjusting layer are present, and the interface is present between both layers.

It was found that, in the PZT film of Example 5 in which the preferentially oriented plane was (100), compared to the PZT films of Comparative examples 4 and 5 in which the preferentially oriented plane was (111), regarding MTF, the lifetime extended by approximately 3 times to 4 times.

The grain diameters are 600 nm in the PZT film of Example 5 and 400 nm in the PZT film of Comparative example 4, and there is a somewhat meaningful difference in the grain diameter, but the difference is not significant. However, the preferentially oriented planes were (100) in the PZT film of Example 5, but (111) in the PZT film of Comparative example 4. This results from the manufacturing conditions, and is because the temperature conditions in the orientation controlling layer calcination step are 175°C in Example 5 and 350°C in Comparative example 4, and the manufacturing conditions of the orientation controlling layers are different.

### <General evaluation>

It was found from the above evaluation results that, according to the PZT-based ferroelectric thin film and the method of manufacturing the same according to the invention, when the orientation controlling layer having a layer thickness, in which the crystal orientation is preferentially controlled in the (100) plane, in a range of 45 nm to 150 nm and the film thickness adjusting layer having the same crystal orientation as the crystal orientation of the orientation controlling layer are provided, and the interface is formed between the orientation controlling layer and the film thickness adjusting layer, it is possible to provide a PZT-based ferroelectric thin film having higher lifetime reliability while having the same dielectric characteristics as a ferroelectric thin film of the related art.

### [Industrial Applicability]

The PZT-based ferroelectric thin film and the method of the same of the invention can be used for an electronic component or an electronic device, such as a thin film capacitor, a capacitor, an IPD, a DRAM memory capacitor, a laminate capacitor, and a piezoelectric element, including a PZT-based ferroelectric thin film which requires higher lifetime reliability.

### [Description of Reference Numerals and Signs]

| | |
|---|---|
| 10 | SUBSTRATE |
| 11 | LOWER ELECTRODE |
| 12 | ORIENTATION CONTROLLING LAYER |
| 13 | FILM THICKNESS ADJUSTING LAYER |
| 14 | INTERFACE |

## Claims

1. A PZT-based ferroelectric thin film formed on a lower electrode of a substrate having the lower electrode in which a crystal plane is oriented in a (111) axis direction, comprising:
an orientation controlling layer which is formed on the lower electrode and has a layer thickness in which a crystal orientation is controlled in a (100) plane preferentially in a range of 45 nm to 150 nm; and
a film thickness adjusting layer which is formed on the orientation controlling layer and has the same crystal orientation as the crystal orientation of the orientation controlling layer,
wherein an interface is present between the orientation controlling layer and the film thickness adjusting layer.

2. The PZT-based ferroelectric thin film according to Claim 1,
wherein an average value of a maximum directed diameter of crystal grains present in the orientation controlling layer is in a range of 200 nm to 5000 nm.

3. The PZT-based ferroelectric thin film according to Claim 1 or 2,
wherein a film thickness of the PZT-based ferroelectric thin film is in a range of 100 nm to 5000 nm.

4. The PZT-based ferroelectric thin film according to Claim 3,
wherein the PZT-based ferroelectric thin film is for a capacitor, and
the film thickness of the PZT-based ferroelectric thin film is in a range of 100 nm to 500 nm.

5. The PZT-based ferroelectric thin film according to Claim 3,
wherein the PZT-based ferroelectric thin film is for a piezoelectric element, and
the film thickness of the PZT-based ferroelectric thin film is in a range of 1000 nm to 5000 nm.

6. A method of manufacturing a PZT-based ferroelectric thin film on a lower electrode by coating, calcining, and then firing so as to crystallize a PZT-based ferroelectric thin film-forming composition on the lower electrode of a substrate having the lower electrode in which a crystal plane is oriented in a (111) axis direction,
wherein some of the PZT-based ferroelectric thin film-forming composition is coated, calcined, and fired on the lower electrode so as to form the orientation controlling layer,
a remainder of the PZT-based ferroelectric thin film-forming composition is coated, calcined, and fired on the orientation controlling layer so as to form a film thickness adjusting layer having the same crystal orientation as the crystal orientation of the orientation controlling layer,
calcination and firing are controlled during the formation of the orientation controlling layer so as to have the interface between the orientation controlling layer and the film thickness adjusting layer, and
a coating amount of some of the PZT-based ferroelectric thin film-forming composition is set so that a layer thickness of the crystallized orientation controlling layer becomes in a range of 45 nm to 150 nm, thereby making crystal orientations in the orientation controlling layer preferentially oriented in a (100) plane.

7. A complex electronic component, such as a thin film capacitor, a capacitor, an IPD, a DRAM memory capacitor, a laminate capacitor, a gate insulator in a transistor, a non-volatile memory, a pyroelectric infrared detecting element, a piezoelectric element, an electro-optic element, an actuator, a resonator, a ultrasonic motor or an LC noise filter element, having a PZT-based ferroelectric thin film manufactured using the method according to Claim 6.
